# EUROPEAN PATENT APPLICATION

(11) **EP 4 561 264 A1**
(43) Date of publication of application: **28.05.2025**
(21) Application number: 23842648.0
(22) Date of filing: 26.04.2023
(51) Int. Cl.: H05B 3/68

(54) **HEATER UNIT**

(30) Priority: 20.07.2022 JP 2022115437
(71) Applicant: NHK Spring Co., Ltd., Yokohama-shi, Kanagawa 236-0004 (JP)
(72) Inventor: ARAKI Yoshihito, Yokohama-shi, Kanagawa 236-0004 (JP)
(74) Representative: dompatent von Kreisler Selting Werner - Partnerschaft von Patent- und Rechtsanwälten mbB
(86) International application number: PCT/JP2023/016492
(87) International publication number: WO 2024/018716

(57) **Abstract**

A heater unit includes a heater, a first plate including a groove portion in which the heater is disposed, a second plate overlapping the first plate so as to cover the groove portion, and a block body disposed between the heater and the second plate. The block body is in contact with the second plate. The groove portion includes a first region having a first depth and a second region having a second depth greater than the first depth. The block body is disposed in the second region.

## Description

### TECHNICAL FIELD

An embodiment of the present invention relates to a heater unit including a heater.

### BACKGROUND ART

A semiconductor device mounted on an electronic device is mainly manufactured by a photolithography process and includes a semiconductor film with a predetermined pattern and an insulating film. These films are formed by a film forming apparatus such as a sputtering apparatus or a CVD (Chemical Vapor Deposition) apparatus, and processed into a predetermined pattern by an etching apparatus. Since the characteristics of a semiconductor device depend on the properties of the film, the film forming conditions are important. One of the parameters of the film forming conditions is temperature, and temperature control in the film forming apparatus or the etching apparatus is very important. For example, Patent Literatures 1 and 2 disclose heater units for heating a substrate.

### CITATION LIST

### PATENT LITERATURE

Patent Literature 1: Japanese laid-open patent publication No. 2004-165085
Patent Literature 2: Japanese laid-open patent publication No. 2004-247210

### SUMMARY OF INVENTION

### TECHNICAL PROBLEM

In recent years, since a heater and a plate included in a heater unit have various shapes, a gap may be formed between the plate and the heater depending on an arrangement of the heater. When the gap is formed, heat generated by the heater is not conducted to the plate and tends to accumulate in the gap. As a result, the heater becomes too hot and a defect such as a heater disconnection occurs.

In view of the above problem, one object of an embodiment of the present invention is to provide a heater unit in which a heater disconnection is suppressed.

### SOLUTION TO PROBLEM

A heater unit according to an embodiment of the present invention includes a heater, a first plate including a groove portion in which the heater is disposed, a second plate overlapping the first plate so as to cover the groove portion, and a block body disposed between the heater and the second plate. The block body is in contact with the second plate. The groove portion includes a first region having a first depth and a second region having a second depth greater than the first depth. The block body is disposed in the second region.

The block body may press the heater.

The block body may be curved along a curved shape of the groove portion.

The heater includes a metal sheath. The metal sheath may be in contact with the block body and a bottom surface of the groove portion.

The metal sheath may include a flat portion in contact with the block body.

The heater includes a joint portion in which a non-heating wire and a heating wire are joined together. The joint portion may overlap the block body.

The heater includes a joint portion in which a non-heating wire and a heating wire are joined together. In a plan view, a position of the joint portion may be substantially aligned with a position of an end of the block body.

The block body may include a protrusion that fits into a recess provided in the second plate.

The block body may include a recess that fits into a protrusion provided in the second plate.

A material of the block body may be the same as a material of the second plate.

The block body may be a part of a member of the second plate.

The second plate may be provided with a plurality of pores.

### ADVANTAGEOUS EFFECTS OF INVENTION

According to a heater unit of an embodiment of the present invention, since no heat pool is formed between a heater and a plate, disconnection of the heater is suppressed. Further, since thermal conduction from the heater to the plate is improved, the heater unit with excellent temperature uniformity and temperature controllability is provided.

### BRIEF DESCRIPTION OF DRAWINGS

FIG. 1 is a schematic perspective view of a heater unit according to an embodiment of the present invention.
FIG. 2 is a schematic exploded perspective view of a heater unit according to an embodiment of the present invention.
FIG. 3 is a schematic cross-sectional view of a heater unit according to an embodiment of the present invention.
FIG. 4A is a schematic cross-sectional view illustrating a heater provided in a heater unit according to an embodiment of the present invention.
FIG. 4B is a schematic cross-sectional view illustrating a heater provided in a heater unit according to an embodiment of the present invention.
FIG. 5A is a schematic cross-sectional view illustrating a heater provided in a heater unit according to an embodiment of the present invention.
FIG. 5B is a schematic cross-sectional view illustrating a heater provided in a heater unit according to an embodiment of the present invention.
FIG. 6 is a schematic enlarged partial cross-sectional view of a heater unit according to an embodiment of the present invention.
FIG. 7 is a schematic enlarged partial cross-sectional view of a heater unit according to an embodiment of the present invention.
FIG. 8 is a schematic enlarged partial cross-sectional view of a heater unit according to an embodiment of the present invention.
FIG. 9 is a schematic partially enlarged cross-sectional view of a heater unit according to an embodiment of the present invention.
FIG. 10 is a schematic enlarged partial cross-sectional view of a heater unit according to an embodiment of the present invention.
FIG. 11 is a schematic enlarged partial cross-sectional view of a heater unit according to an embodiment of the present invention.
FIG. 12 is a schematic enlarged partial cross-sectional view of a heater unit according to an embodiment of the present invention.
FIG. 13 shows a result of a thermal conduction analysis of an Example.
FIG. 14 shows a result of a thermal conduction analysis of a Comparative Example.

### DESCRIPTION OF EMBODIMENTS

Hereinafter, embodiments of the invention disclosed in the present application are described with reference to the drawings. However, the present invention can be implemented in various forms without departing from the gist thereof and should not be construed as being limited to the description of the following exemplary embodiments.

For the sake of clarity of description, the drawings may be schematically represented with respect to widths, thicknesses, shapes, and the like of the respective portions compared with actual embodiments. However, they are merely an example and do not limit the interpretation of the present invention. In the present specification and the respective drawings, components having the same functions as those described with reference to the preceding drawings are denoted by the same reference numerals, and a duplicate description thereof may be omitted.

In the specification and the drawings, the same reference numerals are used when multiple components are identical or similar in general, and reference numerals with a lower or upper case letter of the alphabet may be used when the multiple components are distinguished. Further, reference numerals with a hyphen and a natural number are used when multiple portions of one component are distinguished.

### <First Embodiment>

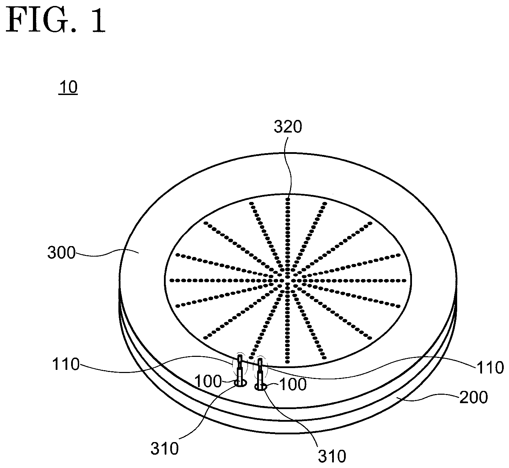

A configuration of a heater unit 10 according to an embodiment of the present invention is described with reference to FIGS. 1 to 6.

### [1. Overview of Configuration of Heater Unit 10]

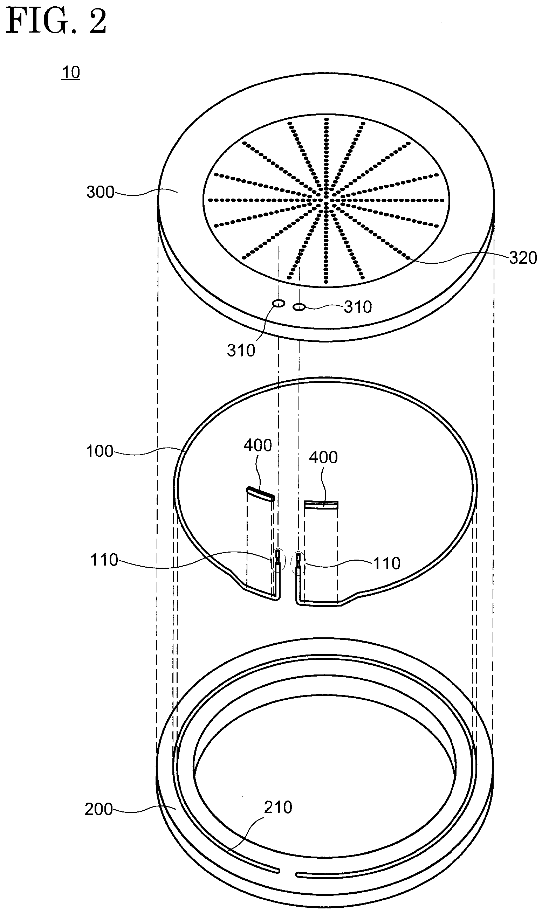

FIG. 1 is a schematic perspective view of the heater unit 10 according to an embodiment of the present invention. FIG. 2 is a schematic exploded perspective view of the heater unit 10 according to an embodiment of the present invention.

As shown in FIGS. 1 and 2, the heater unit 10 includes a heater 100, a first plate 200, a second plate 300, and a block body 400. A groove portion 210 is provided on the outer periphery of the first plate 200. In a plan view, the groove portion 210 has a C-shape along the outer periphery of the first plate 200. That is, the groove portion 210 has two ends and extends from one end to the other end in a curved shape. The second plate 300 includes two through holes 310 and a plurality of pores 320. The two through holes 310 are provided in a part of the outer periphery of the second plate 300. The plurality of pores 320 are provided in the center of the second plate 300. The second plate 300 overlaps the first plate 200 so as to cover the groove portion 210. Specifically, the first plate 200 and the second plate 300 are joined at their outer peripheries so that the end of the groove portion 210 of the first plate 200 and the through hole 310 of the second plate 300 are in communication with each other, and the joined first plate 200 and second plate 300 form the housing of the heater unit 10.

The heater 100 includes two terminal portions 110. The heater 100 is disposed in the groove portion 210 of the first plate 200, and the terminal portions 110 are taken out through the through hole 310 of the second plate 300. The portion of the heater 100 disposed in the groove portion 210 has a curved shape similar to the shape of the groove portion 210. In the heater unit 10, when a current is supplied from the terminal portions 110, the heater 100 can generate heat to heat the second plate 300.

Although not shown in detail, the first plate 200 is provided with a gas supply port. Gas supplied from the gas supply port is heated by the heater 100 and ejected from the pores 320 of the second plate 300. That is, the heater unit 10 can be used as a temperature-adjustable shower head. A gas flow path for controlling the flow of the gas may be provided in the first plate 200, and a heater other than the heater 100 for heating the gas in the first plate 200 may be provided.

In addition, the heater unit 10 is not limited to being used as the temperature-adjustable shower head. The heater unit 10 may also be used as a temperature-adjustable substrate stage.

### [2. Configuration of Heater 100 and Block Body 400]

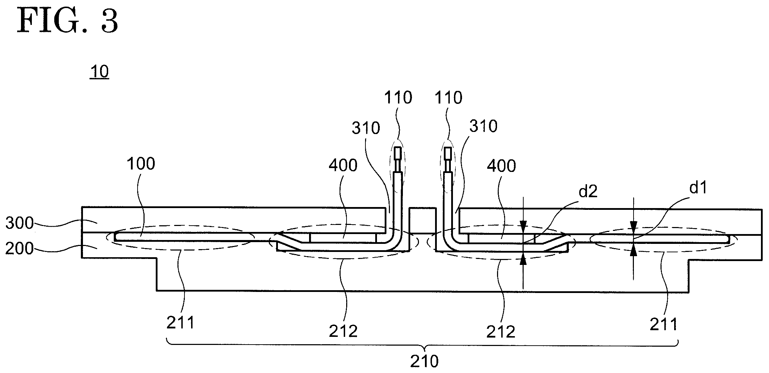

FIG. 3 is a schematic cross-sectional view of the heater unit 10 according to an embodiment of the present invention.

As shown in FIG. 3, the groove portion 210 includes a first region 211 having a first depth d1 and a second region 212 having a second depth d2. Although the first region 211 and the second region 212 are discontinuously connected with a step in FIG. 3, the first region 211 and the second region 212 may be connected such that the first depth d1 and the second depth d2 change continuously. The second region 212 includes an end of the groove portion 210. Therefore, the second region 212 communicates with the through hole 310. The width of the groove portion 210 is approximately equal to the width of the heater 100.

The first depth d1 is approximately equal to the diameter of the heater 100. In the first region 211, the heater 100 is pressed by the second plate 300 and is in contact with the surface of the second plate and the bottom surface of the groove portion 210. In other words, the heater 100 is fitted into the groove portion 210 with almost no gap around its periphery in the first region 211.

The second depth d2 is greater than the first depth d1. From the first region 211 to the second region 212, the heater 100 is bent so as to contact the bottom surface of the groove portion 210 in the second region 212. Further, at the end of the groove portion 210, the heater 100 is bent so as to be inserted into the through hole 310 of the second plate 300. Thus, since the heater 100 is bent in the second region 212, a gap exists around the heater 100. However, the block body 400 is embedded so as to reduce the gap in the heater unit 10. The block body 400 is disposed between the heater 100 and the second plate 300 and is fitted into the groove portion 210. The block body 400 is in contact with the second plate 300 and can transmit pressure from the second plate to the heater 100. Therefore, the heater 100 is pressed by the block body 400 in the second region 212 and is in contact with the block body 400 and the bottom surface of the groove portion 210. In addition, the block body 400 may be curved along the curved shape of the groove portion 210.

The material of the block body 400 is preferably the same as the material of the first plate 200 and the second plate 300. For example, a metal including aluminum, titanium, stainless steel, or an alloy thereof may be used for the block body 400. Further, it is preferable that the block body includes a metal having high thermal conductivity. Such a metal may be selected from metals having a thermal conductivity greater than or equal to 10 W/mK and less than or equal to 430 W/K.

The block body 400 can press and fix the heater 100 disposed in the second region 212 of the groove portion 210. The block body 400 can also conduct heat generated by the heater 100 to the second plate 300. Since the heater 100 is in contact with the second plate 300 in the first region 211, the heater 100 can directly heat the second plate 300. On the other hand, the heater 100 is not in contact with the second plate 300 in the second region 212. However, the block body 400 is in contact with the heater 100 and the surface of the second plate 300 in the second region 212. Therefore, the heater 100 can heat the second plate 300 through the block body 400 in the second region 212.

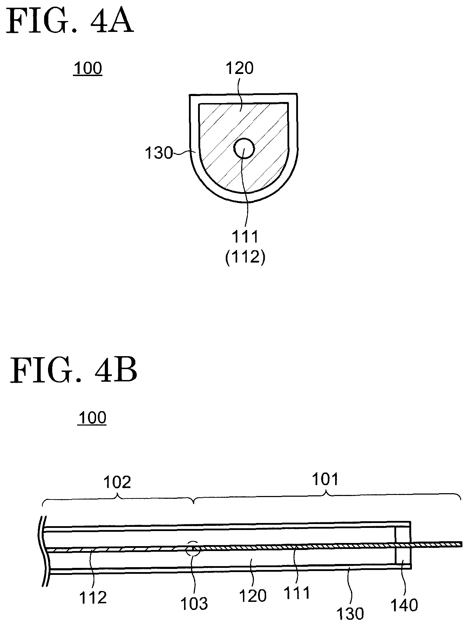

A configuration of the heater 100 is described in detail with reference to FIGS 4A and 4B. FIGS. 4A and 4B are schematic cross-sectional views illustrating the heater 100 provided in the heater unit 10 according to an embodiment of the present invention. Specifically, FIG. 4A is a cross-sectional view cut along a plane perpendicular to an extending direction of the heater 100, and FIG. 4B is a cross-sectional view cut along a plane parallel to the extending direction of the heater 100. In addition, although the heater 100 disposed in the groove portion 210 is bent, the heater 100 having the straight shape is shown in FIG. 4B, for convenience.

The heater 100 includes a non-heating wire 111, a heating wire 112, an insulator 120, a metal sheath 130, and a seal member 140. The non-heating wire 111 and the heating wire 112 are joined at a joint portion 103, and the joined non-heating wire 111 and heating wire 112 are inserted into a metal sheath 130. The metal sheath 130 is filled with the insulator 120. The non-heating wire 111 and the heating wire 112 inserted into the metal sheath 130 are electrically insulated from the metal sheath 130 by the insulator 120. The non-heating wire 111 extends outside one end of the metal sheath 130, and the one end of the metal sheath 130 is sealed by the seal member 140. The non-heating wire 111 which is located outside the metal sheath 130 functions as the terminal portion 110. Here, one portion of the heater 100 in which the non-heating wire 111 is located is referred to as a non-heating portion 101 and the other portion of the heater 100 in which the heating wire 112 is located is referred to as a heating portion 102. The heater 100 mainly generates heat in the heating portion 102. The joint portion 103 is located between the non-heating portion 101 and the heating portion 102.

The cross-sectional shape of the metal sheath 130 is a so-called D-shape in which both ends of a straight line are connected to one curved line. That is, the metal sheath 130 is a cylindrical body having a flat portion and a curved portion. The flat portion of the metal sheath 130 disposed in the groove portion 210 of the first plate 200 is in contact with the second plate 300. When the metal sheath 130 includes the flat portion, a contact region between the flat portion and the second plate 300 increases. Therefore, heat can be efficiently conducted from the heater 100 to the second plate 300. However, the cross-sectional shape of the metal sheath 130 is not limited to the above-described shape, and may be a circle, an ellipse, a polygon, or the like.

In addition, although FIG. 4B shows only one end of the metal sheath 130, the other end of the metal sheath 130 has the same configuration.

The non-heating wire 111 is connected to the heating wire 112 at the joint portion 103 and functions as a lead wire for supplying a current to the heating wire 112. The material of the non-heating wire 111 is a metal such as aluminum (Al), copper (Cu), or nickel (Ni). The non-heating wire 111 has a higher thermal conductivity than the heating wire 112.

When a current is supplied to the heating wire 112, the heating wire 112 generates heat. For example, the material of the heating wire 112 is a metal such as nickel, chromium, iron, or aluminum, or an alloy thereof.

The insulator 120 is provided to prevent the non-heating wire 111 and the heating wire 112 from being in contact with the metal sheath 130 and causing a short circuit. For example, the material of the insulator 120 is magnesium oxide, aluminum oxide, silicon oxide, zirconium oxide, tantalum oxide, boron nitride, aluminum nitride, silicon nitride, zirconium nitride, titanium nitride, tantalum nitride, molybdenum nitride, or niobium nitride. It is preferable that the thermal conductivity of the insulator 120 is greater than or equal to 10 W/mK and less than or equal to 300 W/mK. In addition, the insulator 120 is formed by agglomerating powder of the above material or fine particles obtained by sintering and pulverizing the powder. That is, the insulator 120 is formed by filling the metal sheath 130 with the powder or the fine particles of the above material.

The metal sheath 130 is provided to protect the heating wire 112 from a corrosive atmosphere or an oxidizing atmosphere. For example, the material of the metal sheath 130 is a metal such as aluminum, titanium, nickel, iron, chromium, niobium, or molybdenum, or an alloy thereof. It is preferable that the thermal conductivity of the metal sheath 130 is preferably greater than or equal to 10 W/mK and less than or equal to 430 W/mK.

The sealing member 140 is provided to prevent a decrease in the insulating performance of the insulator 120 due to the intrusion of moisture. For example, the sealing member 140 is an epoxy resin or an acrylic resin.

Specifically, the non-heating wire 111, the heating wire 112, the insulator 120, the metal sheath 130, and the seal member 140 are a nickel wire, a nickel chrome wire, a magnesium oxide, an aluminum tube, and an epoxy resin, respectively. However, the non-heating wire 111, the heating wire 112, the insulator 120, the metal sheath 130, and the seal member 140 are not limited to these materials.

The heater 100 shown in FIGS. 4A and 4B is a so-called double-end sheath heater. A sheath heater has a small outer diameter of the sheath and is flexible. Therefore, the heater 100 can be bent. Further, since the heating wire 112 is protected by the insulator 120, the heater 100 has excellent impact resistance and corrosion resistance.

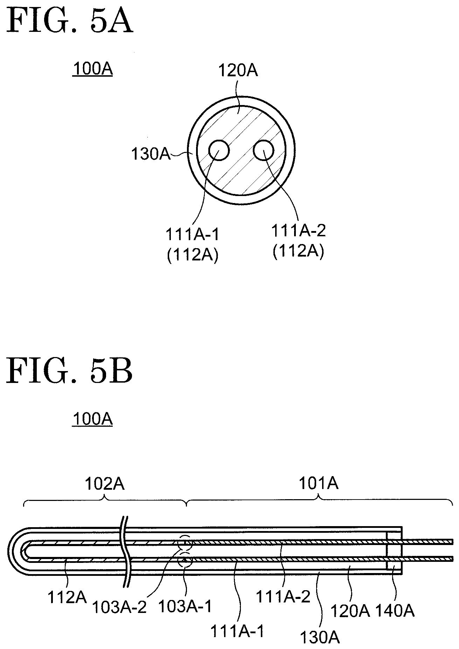

In addition, a configuration of the heater applied to the heater unit 10 is not limited to that of the heater 100. In the following description, a configuration of a heater 100A different from the heater 100 is described with reference to FIGS. 5A and 5B. In addition, when the configuration of the heater 100A is similar to that of the heater 100, the description of the configuration of the heater 100A may be omitted in the following description.

FIGS. 5A and 5B are schematic cross-sectional views illustrating the heater 100A provided in the heater unit 10 according to an embodiment of the present invention. Specifically, FIG. 5A is a cross-sectional view cut along a plane perpendicular to an extending direction of the heater 100A, and FIG. 5B is a cross-sectional view cut along a plane parallel to the extending direction of the heater 100A. In addition, although the heater 100A includes a bent portion, the heater 100A having the straight shape is shown in FIG. 5B, for convenience.

The heater 100A includes a first non-heating wire 111A-1, a second non-heating wire 111A-2, a heating wire 112A, an insulator 120A, a metal sheath 130A, and a seal member 140A. One end of the heating wire 112A is joined to one end of the first non-heating wire 111A-1 at a first joint portion 103A-1, and the other end of the heating wire 112A is joined to one end of the second non-heating wire 111A-2 at a second joint portion 103A-2. The insulator 120A is filled in the metal sheath 130A. The other end of the first non-heating wire 111A-1 and the other end of the second non-heating wire 111A-2 extend outside one end of the metal sheath 130, and the one end of the metal sheath 130A is sealed by the seal member 140. The other end of the metal sheath 130A is a closed tube. Here, one portion of the heater 100A in which the first non-heating wire 111A-1 and the second non-heating wire 111A-2 are located is referred to as a non-heating portion 101A, and the other portion of the heater 100A in which the heating wire 112A is located is referred to as a heating portion 102A. The heater 100A mainly generates heat in the heating portion 102A. A first bonding portion 103A-1 and a second bonding portion 103A-2 are located between the non-heating portion 101 and the heating portion 102.

The heater 100A shown in FIGS. 5A and 5B is a so-called single-end sheath heater. In the heater 100A, since terminals of the lead wires formed of the first non-heating wire 111A-1 and the second non-heating wire 111A-2 are gathered together, a plurality of heaters 100A can be disposed in the heater unit 10.

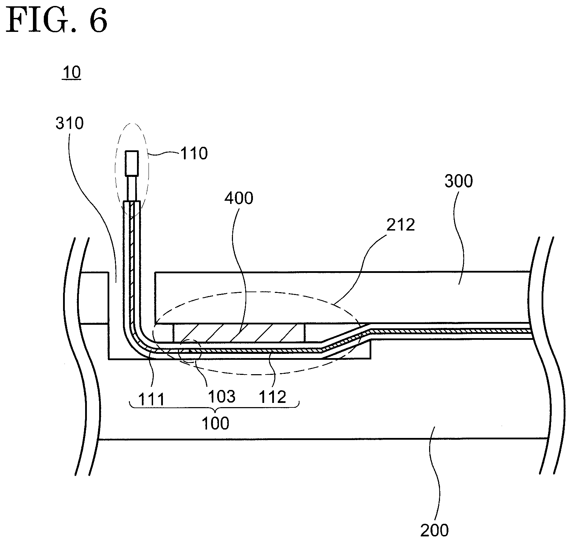

Although the double-ended sheathed heater and the single-ended sheathed heater are described with reference to FIGS. 4A to 5B, it is preferable that in either heater, the portion disposed in the groove portion 210 of the first plate 200 does not include the non-heating portion 101 as much as possible from the viewpoint of temperature uniformity and temperature controllability of the heater unit 10. Therefore, the positional relationship between the joint portion 103 in which the non-heating wire 111 and the heating wire 112 are joined and the block body 400 is described with reference to FIG. 6.

FIG. 6 is a schematic enlarged partial cross-sectional view of the heater unit 10 according to an embodiment of the present invention.

As shown in FIG. 6, the joint portion 103 of the heater 100 is located in the second region 212 so as to overlap the block body 400. However, the joint portion 103 is located not in the center portion of the block body 400 but in the peripheral portion of the block body 400. In other words, the heater 100 is disposed in the second region 212 so that the heating wire 112 overlaps the block body 400 more than the non-heating wire 111. When the joint portion 103 becomes hot, the joint portion 103 is more likely to break. However, since the heater 100 is in contact with the block body 400 in the heater unit 10, heat generated by the heater 100 is conducted to the second plate 300 through the block body 400. Therefore, since heat is less likely to accumulate in the joint portion 103 overlapping the block body 400, the joint point 103 does not become hot. Further, the heater 100 may expand in the process of heating the heater 100 or connecting the terminal to the terminal portion 110. However, since the block body 400 fixes the heater 100 in the heater unit 10, the position of the joint portion 103 is stable. Therefore, when the block body 400 is provided in contact with the heater 100 in the heater unit 10, a defect of disconnection of the joint portion 103 is suppressed.

In addition, the position of the joint portion 103 may be approximately the same as the position of the end of the block body 400 in a plan view. In this case, since the overlap between the heating wire 112 and the block body 400 becomes large, the thermal conduction from the heater 100 to the block body 400 is large and the formation of the heat pool is significantly suppressed.

As described above, the heater unit 10 according to an embodiment of the present invention includes the block body 400 in contact with the heater 100 and the second plate 300. Heat is conducted from the heater 100 to the second plate 300 through the block body 400. Therefore, since the heat pool is less likely to form between the heater 100 and the second plate 300, disconnection of the heater 100 is suppressed. Further, since the thermal conduction from the heater 100 to the second plate 300 is improved even in the vicinity of the terminal portion 110, the heater unit 10 has excellent temperature uniformity and temperature controllability.

In addition, each component of the heater unit 10 can be modified as appropriate. For example, the planar shapes of the first plate 200 and the second plate 300 are not limited to a circular shape. The planar shapes of the first plate 200 and the second plate 300 may be polygonal. The shape of the groove portion 210 is not limited to a C-shape. The shape of the groove portion 210 may be a ring shape without ends. Even in such a case, the same effect as described above can be obtained by providing the block body 400 in contact with the heater 100 and the second plate 300.

### < Modification 1 of First Embodiment>

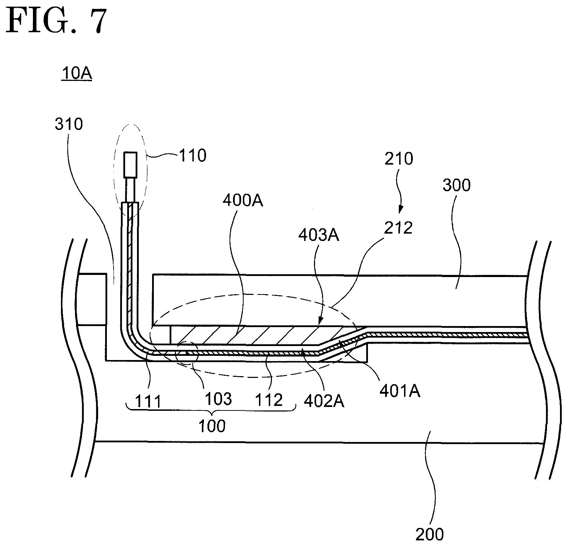

A heater unit 10A which is a modification of the heater unit 10 will be described with reference to FIG. 7. When a configuration of the heater unit 10A is similar to that of the heater unit 10, the description of the configuration of the heater unit 10A may be omitted.

FIG. 7 is a schematic enlarged partial cross-sectional view of the heater unit 10A according to an embodiment of the present invention.

As shown in FIG. 7, the heater unit 10A includes the heater 100, the first plate 200, the second plate 300, and a block body 400A. In the second region 212 of the groove portion 210 of the first plate 200, the block body 400A is disposed between the heater 100 and the second plate 300 and fitted into the groove portion 210. As a result, in the second region 212, the heater 100 is pressed by the block body 400A and is in contact with the block body 400A and the bottom surface of the groove portion 210.

The block body 400A includes a slope 401A formed along the bend of the heater 100. That is, the block body 400A includes the slope 401A that connects a bottom surface 402A and an upper surface 403A. It is preferable that the slope 401A is in contact with the heater 100. However, it is sufficient that at least a part of the slope 401A is in contact with the heater 100, and it is not necessary that the entire slope 401A is in contact with the heater 100. The slope 401A may be a flat surface or a curved surface.

In the heater unit 10A, since the block body 400A has a shape formed along the bend of the heater 100, the gap is reduced between the heater 100 and the second plate 300. As a result, the heat pool is less likely to form between the heater 100 and the second plate 300. Further, since the thermal conduction from the heater 100 to the second plate 300 is improved through the block body 400A, the heater unit 10A has excellent temperature uniformity and temperature controllability.

### <Modification 2 of First Embodiment>

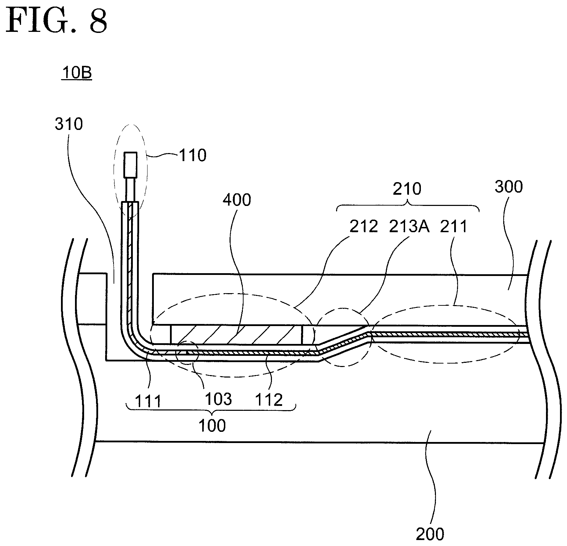

A heater unit 10B which is a modification of the heater unit 10 is described with reference to FIG. 8. When a configuration of the heater unit 10B is similar to that of the heater unit 10, the description of the configuration of the heater unit 10B may be omitted.

FIG. 8 is a schematic enlarged partial cross-sectional view of the heater unit 10B according to an embodiment of the present invention.

As shown in FIG. 8, the heater unit 10B includes the heater 100, the first plate 200, the second plate 300, and the block body 400. The groove portion 210 provided in the outer periphery of the first plate 200 includes the first region 211, the second region 212, and a third region 213A between the first region 211 and the second region 212. The third region 213A includes a bottom surface of the groove portion 210 that is inclined along the bend of the heater 100. That is, the bottom surface of the groove portion 210 is provided in the third region 213A so as to reduce the step between the bottom surface of the groove portion 210 in the first region 211 and the bottom surface of the groove portion 210 in the second region 212. It is preferable that the heater 100 is in contact with the bottom surface of the groove portion 210 in the third region 213A. However, it is sufficient that at least a portion of the bottom surface of the groove portion 210 is in contact with the heater 100, and it is not necessary that the entire bottom surface of the groove is in contact with the heater 100.

In the heater unit 10B, since the bottom surface of the groove portion 210 includes a shape formed along the bend of the heater 100, the gap is reduced between the heater 100 and the first plate 200. Therefore, the heat pool is less likely to form between the heater 100 and the first plate 200. Since the thermal conduction from the heater 100 to the first plate 200 is improved, the heater unit 10B has excellent temperature uniformity and temperature controllability.

### <Modification 3 of First Embodiment>

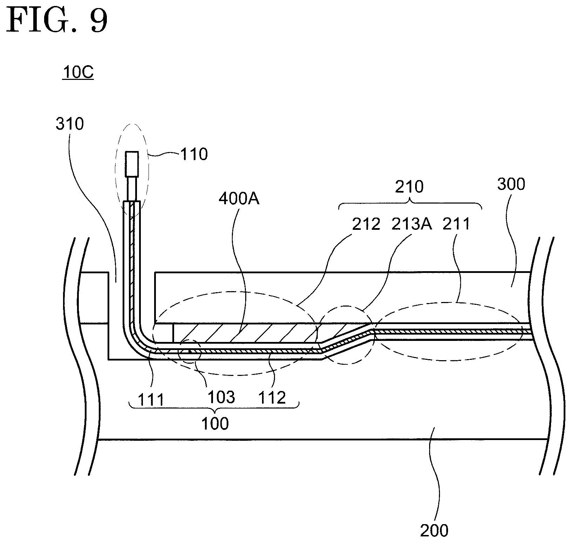

A heater unit 10C which is a modification of the heater unit 10 is described with reference to FIG. 9. When a configuration of the heater unit 10C is similar to the configuration of the heater unit 10, the heater unit 10A, or the heater unit 10B, the description of the configuration of the heater unit 10B may be omitted.

FIG. 9 is a schematic enlarged partial cross-sectional view of a heater unit 10C according to an embodiment of the present invention.

As shown in FIG. 9, the heater unit 10C includes the heater 100, the first plate 200, the second plate 300, and the block body 400A. In the second region 212 of the groove portion 210 of the first plate 200, the block body 400A is disposed between the heater 100 and the second plate 300 and fitted into the groove portion 210. As a result, the heater 100 is pressed by the block body 400A in the second region 212 and is in contact with the block body 400A and the bottom surface of the groove portion 210. Further, the groove portion 210 provided in the outer periphery of the first plate 200 includes the first region 211, the second region 212, and the third region 213A between the first region 211 and the second region 212. The heater 100 is in contact with the bottom surface of the groove portion 210 in all of the first region 211, the second region 212, and the third region 213A.

In the heater unit 10C, since the block body 400A has a shape formed along the bend of the heater 100, the gap is reduced between the heater 100 and the second plate 300. Further, since the bottom surface of the groove portion 210 has a shape formed along the bend of the heater 100, the gap is reduced between the heater 100 and the first plate 200. Therefore, the heat pool is unlikely to form between the heater 100 and the first plate 200 and between the heater 100 and the second plate 300. In the heater unit 10C, not only the thermal conduction from the heater to the first plate but also the thermal conduction from the heater 100 to the second plate 300 through the block body 400A is improved. Therefore, the heater unit 10C has excellent temperature uniformity and temperature controllability.

Although the heater units 10A to 10C are described above as modifications of the heater unit 10, modifications of the heater unit 10 are not limited to these modifications.

### <Second Embodiment>

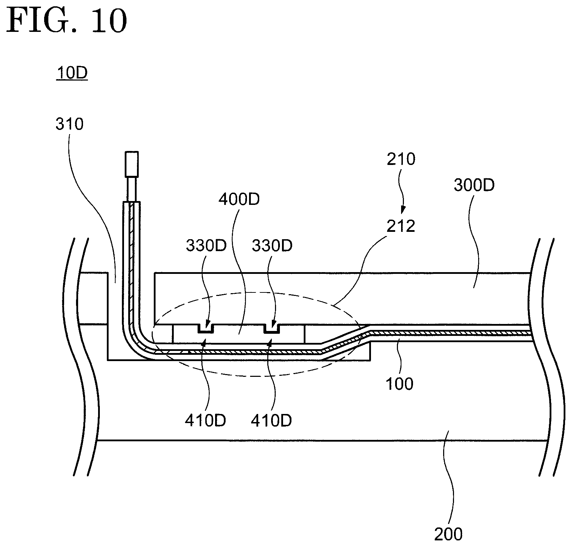

A configuration of a heater unit 10D, which is different from the heater unit 10, is described with reference to FIG. 10. In addition, when the configuration of the heater unit 10D is similar to the configuration of the heater unit 10, the description of the configuration of the heater unit 10D may be omitted in the following description.

FIG. 10 is a schematic enlarged partial cross-sectional view of the heater unit 10D according to an embodiment of the present invention.

As shown in FIG. 10, the heater unit 10D includes the heater 100, the first plate 200, a second plate 300D, and a block body 400D. In the second region 212 of the groove portion 210 of the first plate 200, the block body 400D is disposed between the heater 100 and the second plate 300D and fitted into the groove portion 210. As a result, the heater 100 is pressed by the block body 400D in the second region 212 and is in contact with the block body 400D and the bottom surface of the groove portion 210.

The second plate 300 includes a protrusion 330D protruding from the surface. The block body 400D includes a recess 410D recessed from the surface. The protrusion 330D of the second plate 300D and the recess 410D of the block body 400D can be fitted together. That is, the block body 400D is disposed in the second region 212 so that the recess 410D fits into the protrusion 330D. Therefore, the block body 400D can be easily aligned in the second region 212 in the heater unit 10D.

As described above, the heater unit 10D according to an embodiment of the present invention includes the heater 100 and the block body 400D in contact with the second plate 300D. Therefore, the heater unit 10D also has excellent temperature uniformity and temperature controllability. Further, the second plate 300D and the block body 400D each include a convex portion 330D and a concave portion 410D, and the protrusion 330D and the recess 410D are fitted together to allow the block body 400D to be disposed at a predetermined position. Therefore, it is easy to align the block body 400D in the second region 212 in the heater unit 10D, and the manufacturing process of the heater unit 10D can be simplified.

### <Modification of Second Embodiment>

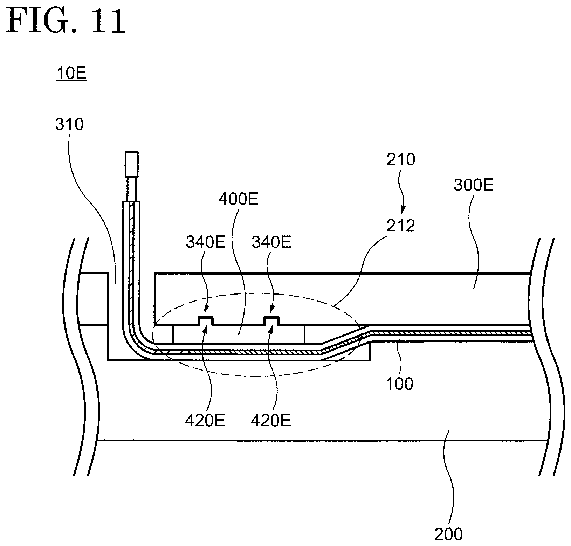

A heater unit 10E, which is a modification of the heater unit 10D, is described with reference to FIG. 11. In addition, modifications of the heater unit 10D are not limited to the heater unit 10E described in the following description. Further, when a configuration of the heater unit 10E is similar to that of the heater unit 10D, the description of the configuration of the heater unit 10E may be omitted.

FIG. 11 is a schematic enlarged partial cross-sectional view of the heater unit 10E according to an embodiment of the present invention.

As shown in FIG. 11, the heater unit 10E includes the heater 100, the first plate 200, a second plate 300E, and a block body 400E. In the second region 212 of the groove portion 210 of the first plate 200, the block body 400E is disposed between the heater 100 and the second plate 300E and fitted into the groove portion 210. As a result, the heater 100 is pressed by the block body 400E in the second region 212, and is in contact with the block body 400E and the bottom surface of the groove portion 210.

The second plate 300 includes a recess 340C recessed from the surface. The block body 400E includes a protrusion 420E protruding from the surface. The recess 340C of the second plate 300E and the protrusion 420E of the block body 400E can be fitted together. That is, the block body 400E is disposed in the second region 212 so that the protrusion 420E fits into the recess 340C. Therefore, the block body 400E can be easily positioned in the second region 212 in the heater unit 10E.

As described above, the heater unit 10E according to an embodiment of the present invention includes the heater 100 and the block body 400E in contact with the second plate 300E. Therefore, the heater unit 10E also has excellent temperature uniformity and temperature controllability. Further, the second plate 300E and the block body 400E each include the recess 340C and the protrusion 420E, and the recess 340C and the protrusion 420E are fitted together to allow the block body 400E to be disposed at a predetermined position. Therefore, it is easy to align the block body 400E in the second region 212 in the heater unit 10E, and the manufacturing process of the heater unit 10E can be simplified.

### <Third Embodiment>

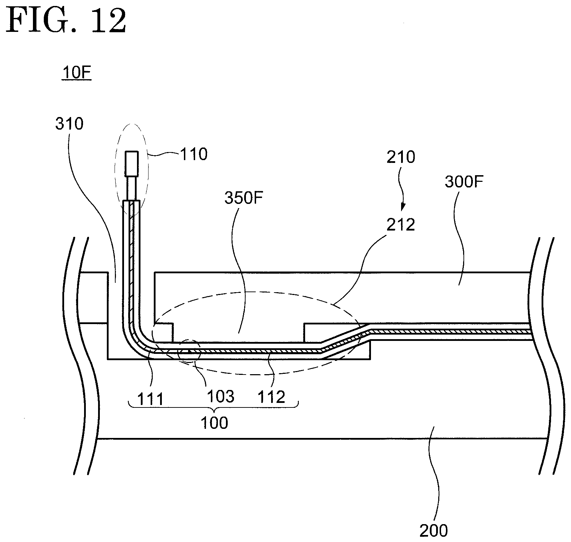

A configuration of a heater unit 10F, which is different from the heater units 10 to 10E, is described with reference to FIG. 12. In addition, when the configuration of the heater unit 10F is similar to the configurations of the heater units 10 to 10E, the description of the configuration of the heater unit 10F may be omitted in the following description.

FIG. 12 is a schematic enlarged partial cross-sectional view of the heater unit 10D according to an embodiment of the present invention.

As shown in FIG. 12, the heater unit 10F includes the heater 100, the first plate 200, and a second plate 300F. The second plate 300F is provided with a pressing portion 350F (or a convex pressing portion 350F protruding from the surface) that overlaps the second region 212 of the first plate 200 and has a raised portion on the surface. That is, the pressing portion 350F is a part of the member of the second plate 300F. In the second region 212, the heater 100 is pressed by the pressing portion 350F and is in contact with the pressing portion 350F and the bottom surface of the groove portion 210.

The second plate 300F provided with the pressing portion 350F can be said to have a configuration in which the above-described second plate 300 and the block body 400 are integrated together.

As described above, the heater unit 10F according to an embodiment of the present invention includes the second plate 300F provided with the pressing portion 350F in contact with the heater 100. Heat from the heater 100 is conducted from the pressing portion 350F to the second plate 300F. Therefore, since no heat pool is formed between the heater 100 and the second plate 300F, disconnection of the heater 100 is suppressed. Further, since the thermal conduction from the heater 100 to the second plate 300 is improved even in the vicinity of the terminal portion 110, the heater unit 10 has excellent temperature uniformity and temperature controllability.

### [EXAMPLES]

A thermal conduction analysis was performed on the heater unit 10 according to the First Embodiment (Example) and a heater unit (Comparative Example) that does not include the block body 400. SolidWorks (manufactured by Dassault Systems) was used for the thermal conduction analysis.

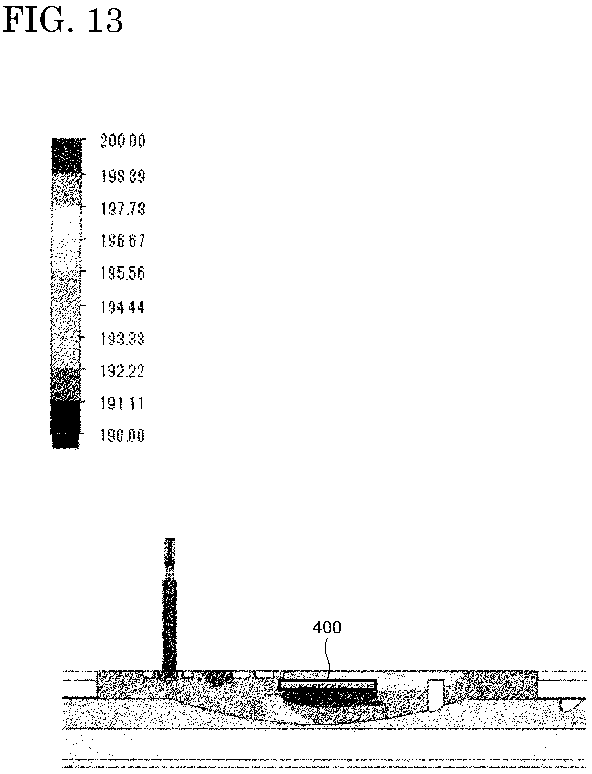

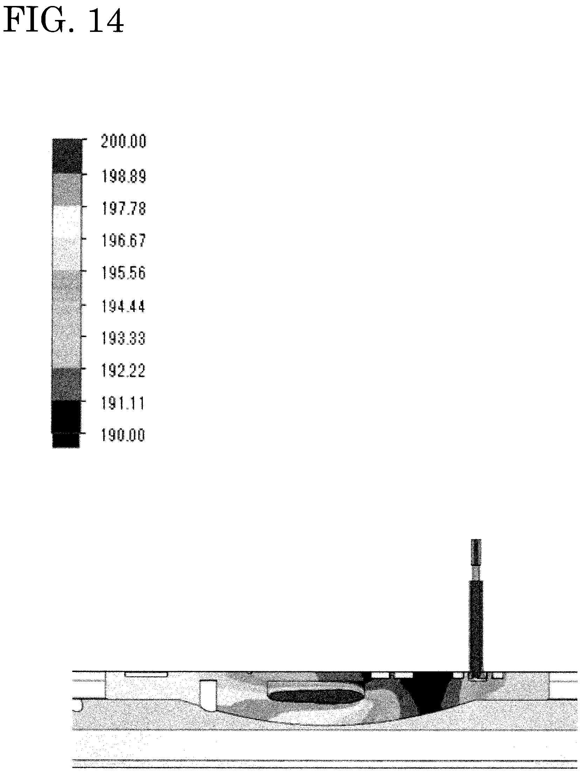

FIG. 13 shows a result of the thermal conduction analysis of the Example. FIG. 14 shows a result of the thermal conduction analysis of the Comparative Example. In FIGS. 13 and 14, the temperature is shown to increase as the color changes from blue to red (from a color with a short wavelength to a color with a long wavelength).

As shown in FIG. 13, when the block body 400 is provided in contact with the heat source (red region in the figure), a region over the block body 400 is yellow, and it is found that the temperature of the region over the block body 400 is high. This is considered to be due to heat from the heat source being conducted to the plate through the block body 400. In other words, it is found that the thermal conductivity to the plate is improved in the Example.

On the other hand, as shown in FIG. 14, when the block body 400 is not provided, the heat from the heat source is not conducted, the region over the heat source is blue, and the temperature of this region does not rise. This is considered to be due to the gap around the heat source forming the heat pool. In other words, it is found that the thermal conductivity to the plate is reduced in the Comparative Example.

As can be seen from the results of the above Example and Comparative Example, the heater unit 10 including the block body 400 can conduct heat to the second plate 300 through the block body 400 even in the vicinity of the through hole 310 of the second plate 300 from which the terminal portion 110 is taken out. Therefore, the heater unit 10 has excellent temperature uniformity and temperature controllability.

Each of the embodiments described above as the embodiments of the present invention can be appropriately combined and implemented as long as no contradiction is caused. Further, the addition, deletion, or design change of components, or the addition, deletion, or condition change of processes as appropriate by those skilled in the art based on each of embodiments are also included in the scope of the present invention as long as they are provided with the gist of the present invention.

Further, it is understood that, even if the effect is different from those provided by each of the above-described embodiments, the effect obvious from the description in the specification or easily predicted by persons ordinarily skilled in the art is apparently derived from the present invention.

### REFERENCES SIGN LIST

10, 10D, 10E: heater unit, 100, 100A: heater, 101, 101A: non-heating portion, 102, 102A: heating portion, 103,103A: joint portion, 110: terminal portion, 111, 111A: non-heating wire, 112, 112A: heating wire, 120,120A: insulator, 130, 130A: metal sheath, 140, 140A: sealing member, 200: first plate, 210: groove portion, 211: first region, 212: second region, 300, 300D, 300E: second plate, 310: through hole, 320: pore, 330D: protrusion, 340C: recess, 350F: pressing portion, 400, 400A, 400D, 400E: block body, 410D: recess, 420E: protrusion

## Claims

1. A heater unit, comprising:
a heater;
a first plate comprising a groove portion in which the heater is disposed;
a second plate overlapping the first plate so as to cover the groove portion; and
a block body disposed between the heater and the second plate,
wherein the block body is in contact with the second plate,
wherein the groove portion comprises:
a first region having a first depth; and
a second region having a second depth greater than the first depth, and
wherein the block body is disposed in the second region.

2. The heater unit according to claim 1, wherein the block body presses the heater.

3. The heater unit according to claim 1, wherein the block body is curved along a curved shape of the groove portion.

4. The heater unit according to claim 1,
wherein the heater comprises a metal sheath, and
wherein the metal sheath is in contact with the block body and a bottom surface of the groove portion.

5. The heater unit according to claim 4, wherein the metal sheath comprises a flat portion in contact with the block body.

6. The heater unit according to claim 1,
wherein the heater comprises a joint portion in which a non-heating wire and a heating wire are joined together, and
wherein the joint portion overlaps the block body.

7. The heater unit according to claim 1,
wherein the heater comprises a joint portion in which a non-heating wire and a heating wire are joined together, and
wherein in a plan view, a position of the joint portion is substantially aligned with a position of an end of the block body.

8. The heater unit according to claim 1, wherein the block body comprises a protrusion that fits into a recess provided in the second plate.

9. The heater unit according to claim 1, wherein the block body comprises a recess that fits into a protrusion provided in the second plate.

10. The heater unit according to claim 1, wherein a material of the block body is a same as a material of the second plate.

11. The heater unit according to claim 1, wherein the block body is a part of a member of the second plate.

12. The heater unit according to claim 1, wherein the second plate is provided with a plurality of pores.
